# EUROPEAN PATENT APPLICATION

(11) **EP 0 658 079 A1**
(43) Date of publication of application: **14.06.1995**
(21) Application number: 94119509.1
(22) Date of filing: 09.12.1994
(51) Int. Cl.: H05K 9/00, G05B 19/042

(54) **Electro-magnetic field encapsulating shielding for a modular universal main logic board**

(30) Priority: 09.12.1993 US 163773
(71) Applicant: PITNEY BOWES INC., Stamford Connecticut 06926-0700 (US)
(72) Inventor: Muller, Arno, Westport, CT 06880 (US); Nambudiri, Easwaran C.N., Port Chester, New York 10573 (US); Pagliaro, Peter A., West Haven, CT 06516 (US); Pantino, Russ R., New Hyde Park, New York 11040 (US)
(74) Representative: Avery, Stephen John

(57) **Abstract**

EMF shielding is provided for a logic board (13) having a number of integrated circuit units (30,35,38,40,32) surface mounted to the logic board (13). The logic board is a laminate of a number of circuit layers. The integrated circuits surface mounted to the top circuit layer are a microprocessor (30), a number of memory units and an application specific integrated circuit surface. Additional circuit components are mounted to both the top and bottom circuit layers. Electrical lines provide electrical communication perpendicularly between the circuit layers and horizontally on the surface of the respective layers to and from the integrated circuits. The top circuit layer has a conductive material (19) formed contiguously around the integrated circuits mounted to the top layer of the logic board (13) and a top cover composed of EMF shielding material is fixably mounted to the logic board (13) to enclose the integrated circuits mounted to the top layer of the logic board (13). The periphery of the top cover is in contiguous contact with the conductive material (19). In like manner, the bottom circuit layer has a conductive material formed contiguously around the integrated circuits mounted to the bottom layer of the logic board and a bottom cover composed of EMF shielding material fixably mounted to the logic board to enclose the integrated circuits mounted to the bottom layer of the logic board.

## Description

The present invention relates to electro-magnetic field (EMF) shielding and, more particularly, EMF shielding of the main logic board for a processing system, for example, a postage meter mailing machine and like systems.

It is conventional in envelope mail processing systems to define a unique microprocessor based system controller and EMF shielding for each system model. This conventional practice has been followed in order to accommodate the varying control requirements and power supply requirements between system models. Variations in the control system configuration and power supply required to communicate, e.g., the number and size of drive motors and other device modules such as the display size and type, have necessitated developing unique EMF shielding for each processing system.

It is an objective of the present invention to present a main logic board configuration and modular EMF shielding therefor.

It is a further objective of the present invention to present a main logic board configuration and modular shielding therefor.

According to one aspect of the invention, there is provided an EMF shielding arrangement for a logic board having a plurality of integrated circuit units surface mounted to said logic board, characterised by, said logic board being a laminate of a plurality of circuit layers having a top circuit layerand a bottom circuit layer, said integrated circuit units being surface mounted to the top surface of said top circuit layer, said circuit layers and to said bottom circuit layers, electrical communication means for providing electrical communication perpendicularly between said circuit layers and on the surface of said respective layers to and from said integrated circuit units, said top circuit layer having a conductive material formed around said integrated circuits mounted to the top layer of said logic board, and a top cover composed of EMF shielding material fixably mounted to the logic board to enclose said integrated circuits mounted to the top layer of said logic board and having said conductive material in contiguous contact, said logic board having a plurality of buffers in bus communication with a coupler located outside of said top cover.

For a better understanding of the invention and to show the same may be carried into effect, reference will now be made, by way of example, to the accompanying drawings, in which:
Fig. 1 is a top view of a main logic board having EMF shielding covers in accordance with one embodiment of the present invention;
Fig. 2 is a side view of a main logic board having EMF shielding covers in accordance with Fig. 1;
Fig. 3 is a top view of the main logic board layout;
Fig. 4 is a schematic of the bus communication between the main logic board control components;
Fig. 5 is an exploded view of the laminated layers of the main logic board; and
Fig. 6 is a schematic view of the mounting of one of the communication buffers mounted to the bottom circuit layer of the main logic board.

A main logic board is comprised of a plurality of laminated circuit layers having the main system controller components being a microprocessor, a plurality of memory units and an application specific integrated circuit surface mounted to the top circuit board and a plurality of circuit components mounted to both the top and bottom layers having electrical communication being provided perpendicularly between the layers and on the surface of the respective layers. A plurality of buffers are mounted to one of the outer layers of the main board in communication to a coupler mounted to either the top or bottom layer board.

A top cover and bottom cover are secured by a screw which extends through the top cover, laminate and bottom cover to threadably engage a nut. This arrangement encloses the microcontroller system and locates the laminate in-between the covers and such that perimeters of the top and bottom covers are in contiguous contact with respective conductive rings. The placement of the top cover locates the pin connector and communication buffers outside of the top cover.

More specifically, mounted to the first or circuit layer of the laminated plate below the top cover and enclosed by one of the conductive rings is the microcontroller system. The microcontroller system is comprised of a microprocessor, static random access memory, ASIC, memory, non-volatile memories, optical read only memory and a number of system integrated circuit chips (IC).

Bus and control line communication between the microprocessor, ASIC, other IC's and memory units extends in a conventional manner through and between the laminate layers with the subsequently noted exceptions. The ASIC is in independent bus communication with the respective communication buffers which are, in turn, in independent bus communication with a respective portion of the pin connector. The respective communication bus lines allow the circuit layers to communicate with a number of resistors and like electronic analog components for proper signal handling.

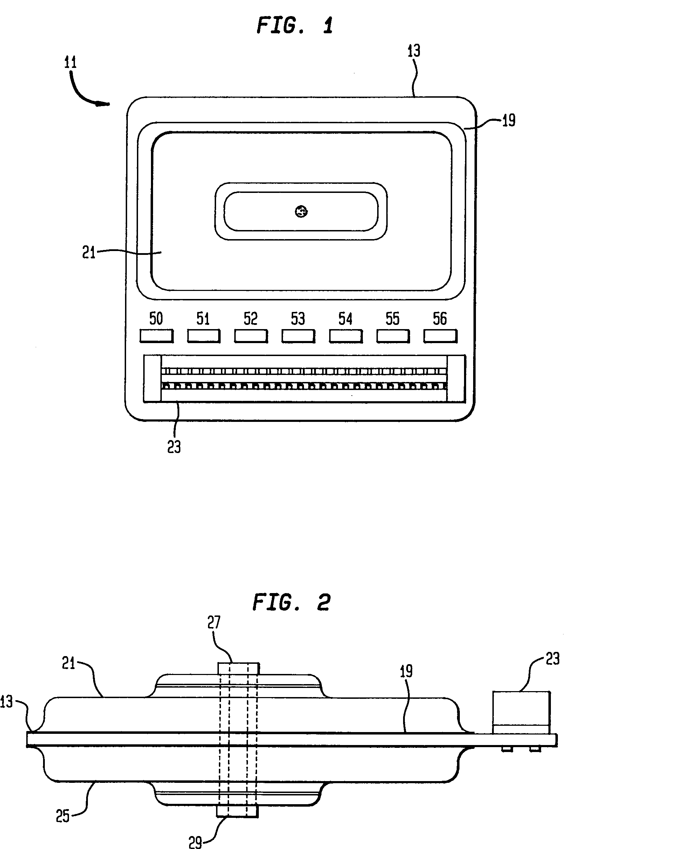

Referring to Figs. 1 and 2 in more detail, a microprocessor system, generally indicated as 11, is mounted to a laminated plate, generally indicated as 13. The laminated plate 13 has conductive rings 19 adhered to the top and bottom surfaces, respectively, and a pin connector 23 is mounted to the top surface of the mounting plate 13. A top cover 21 and bottom cover 25 are secured by a screw 27 and nut 29 to locate the laminated plate 13 in-between and in a manner such that the perimeters of the top and bottom covers 21 and 25 contact the respective conductive ring 19. The placement of the top cover 21 locates the pin connector 23 outside of the cover and a plurality of communication buffers 50, 51, 52, 53, 54, 55 and 56 are mounted to the top surface of the laminated plate 13 between the top cover 21 and the pin connector 23 of the top surface of the laminated plate 13.

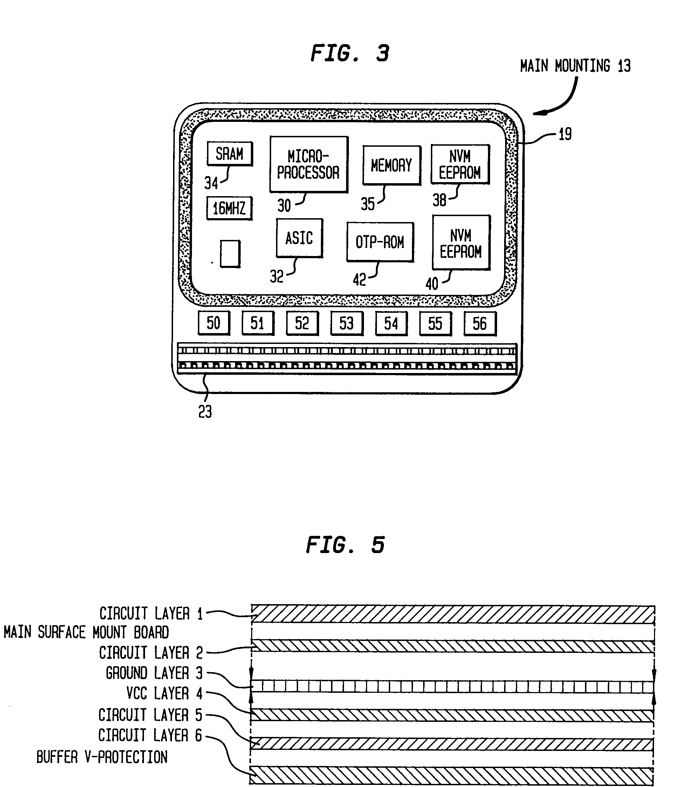

Referring to Fig. 3, mounted to the first circuit layer of the laminated plate 13 within the top cover 21 and conductive ring 19 is a microprocessor system comprised of a microprocessor 30, static random access memory 34, ASIC 32, memory 35, non-volatile memories 38 and 40, optical read only memory 42 and a number of further system components' (not shown).

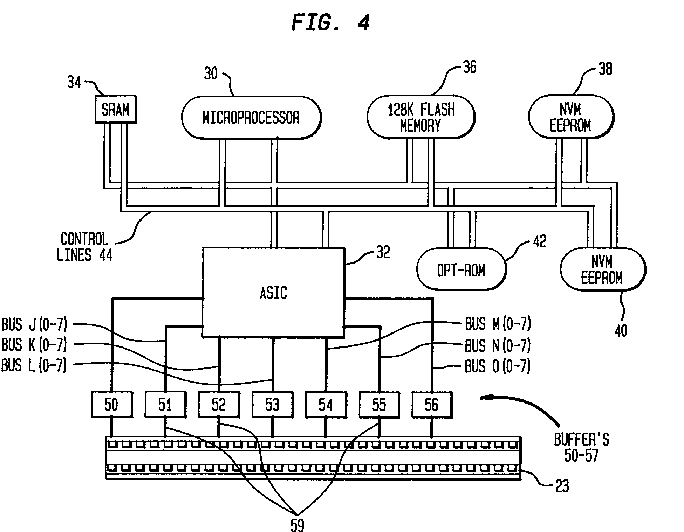

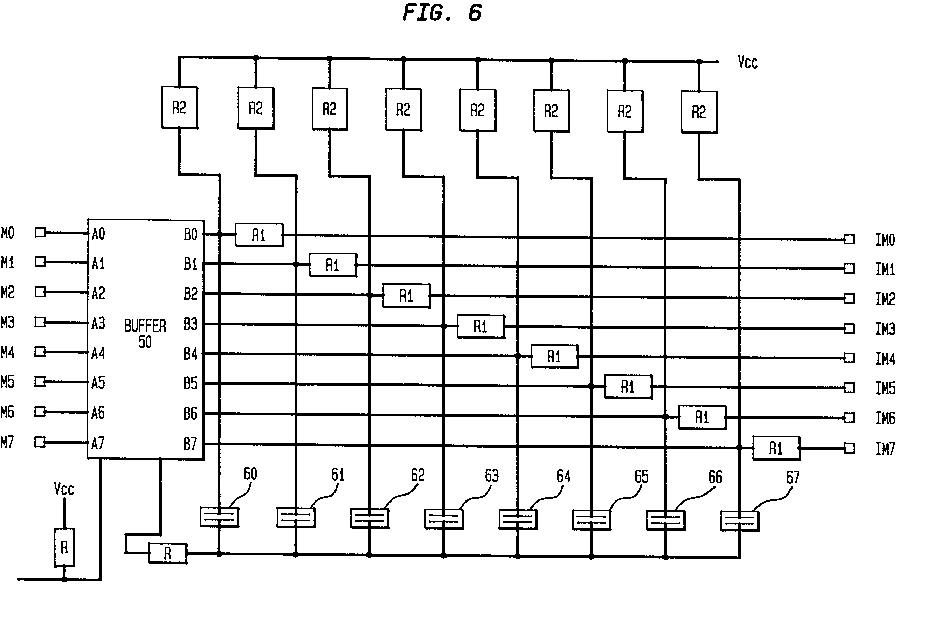

Referring to Fig. 4, schematically represented is the bus communication between the microprocessor 30, ASIC 32, and memory units 34, 36, 38, 40 and 42. The ASIC 32 is in independent bus J, K, L, M, N, O and P communication with respective buffers 50, 51, 52, 53, 54, 55 and 56. In turn, buffers 50, 51, 52, 53, 54, 55 and 56 are in communication with respective portions of the pin connector 23 by a respective bus line 59. Referring to Fig. 6, the buffer 54 is illustrative also of buffers 50 to 56. A bus 59 communicates the output side of the buffer 54 to a plurality of pins IM0 to IM7 of the connector 23. The bus 59 is comprised of a plurality of lines 59a to 59h which connect at one end to the respective terminals IMO through IM7 of the pin connector 23 mounted on circuit layer 1 (Fig. 5). The bus lines 59a through 59h extends through circuit layer 1 to circuit layer 6 (Fig. 5) to respective resistors R1 surface mounted to the underside of circuit layer 6. The outputs of respective resistors R1 are directed from circuit layer 6 to circuit layer 1 and thence to the respective output pins B0 to B7 of the buffer 54. The buffer 54 has inputs A0 to A7 which inputs A0 to A7 are in line communication with a plurality of lines (M0 to M7) of the bus connected to ASIC 32.

Each of the bus lines 59a to 59h has a respective resistor R2 in line communication with the one side of a respective resistor R1. The other side of each resistor R2 is in line communication with a reference voltage Vcc from Vcc layer 4. Also, each of the bus lines 59a to 59h has a corresponding capacitor 60 to 67 in line communication with the one side of a respective resistor R1.

## Claims

1. An EMF shielding arrangement for a logic board (13) having a plurality of integrated circuit units (11) surface mounted to said logic board, characterised by:
said logic board (13) being a laminate of a plurality of circuit layers (1 to 6) having a top circuit layer (1) and a bottom circuit layer (6),
said integrated circuit units (13) being surface mounted to the top surface of said top circuit layer (1), said circuit layers and to said bottom circuit layers (6),
electrical communication means (59) for providing electrical communication perpendicularly between said circuit layers and on the surface of said respective layers to and from said integrated circuit units,
said top circuit layer (1) having a conductive material (19) formed around said integrated circuits mounted to the top layer of said logic board (13), and
a top cover (21) composed of EMF shielding material fixably mounted to the logic board to enclose said integrated circuits mounted to the top layer of said logic board and having said conductive material (19) in contiguous contact, said logic board having a plurality of buffers (50-56) in bus communication with a coupler (23) located outside of said top cover (21).

2. An EMF shielding arrangement as claimed in claim 1 further comprising:
said bottom circuit layer having a conductive material (19) formed around said integrated circuit units mounted to the bottom layer of said logic board (13), and
a bottom cover (25) composed of EMF shielding material fixably mounted to the logic board to enclose said integrated circuits mounted to the bottom layer of said logic board and having said conductive material (19) in contiguous contact.

3. An EMF shielding arrangement as claimed in claim 2 wherein said top and bottom covers are detachably mounted to said logic board.

4. An EMF shielding arrangement as claimed in any preceding claim wherein said integrated circuits mounted to said top layer comprise:
a microprocessor (30), memory units (35,38,40) and an integrated circuit (32) surface mounted to the top one of said circuit layers and a plurality of further circuit components mounted to both the top and bottom circuit layers, and
electrical communication means (59) for providing electrical communication perpendicularly between said circuit layers and on the surface of said respective layers to and from said microprocessor (30), said memory units (35,.38,40), circuit components and said integrated circuit (32).

5. An EMF shielding arrangement for a logic board (13) having a plurality of integrated circuits units surface mounted to said logic board, characterised by:
said logic board (13) being a laminate of a plurality of circuit layers (1-6),
said integrated circuits being surface mounted to the top one of said circuit layers and to the bottom circuit layer, said integrated circuits mounted to the top one of said circuit layers including a microprocessor (30) and a memory unit (35,38,40) surface mounted to the top one of said circuit layers and a plurality of further circuit components mounted to both the top and bottom circuit layers,
electrical communication means (59) for providing electrical communication perpendicularly between said circuit layers and on the surface of said respective layers to and from said integrated circuits,
said top circuit layer (1) having a conductive material (19) formed around said integrated circuits mounted to the top layer (1) of said logic board,
a top cover (21) composed of EMF shielding material fixably mounted to the logic board (13) to enclose said integrated circuits mounted to the top layer of said logic board and having said conductive material (19) in contiguous contact,
said bottom circuit layer having a conductive material (19) formed contiguously around said circuits components mounted to said bottom layer of said logic board (13),
a bottom cover (25) composed of EMF shielding material fixably mounted to the logic board (13) to enclose said components mounted to the bottom layer of said logic board and having said conductive material (19) in contiguous contact, and
a plurality of buffers (50-56) in bus communication with a coupler (23) located outside of said covers.

6. An EMF shielding arrangement as claimed in claim 4 or 5 wherein said integrated circuit comprises microprocessor control units for an electronic postage meter.

7. An electronic postage meter or mailing machine comprising an EMF shielding arrangement according to any preceding claim.
